# EUROPEAN PATENT APPLICATION

(11) **EP 3 950 076 A1**
(43) Date of publication of application: **09.02.2022**
(21) Application number: 21188983.7
(22) Date of filing: 20.01.2012
(51) Int. Cl.: A63F 13/23, G06F 3/01, A63F 13/428, A63F 13/21

(54) **METHOD FOR CONTROLLING MAN-MACHINE INTERACTION AND APPLICATION THEREOF**

(30) Priority: 11.02.2011 CN 201110036356; 30.12.2011 CN 201110458168
(62) Divisional of application: 12745158.1
(71) Applicant: Huang, Defeng, Fujian 363000 (CN)
(72) Inventor: Huang, Defeng, Fujian 363000 (CN)
(74) Representative: HWP Intellectual Property

(57) **Abstract**

The present invention A man-machine interaction controlling method and applications thereof are provided. A man-machine interaction controlling method, wherein a user performs smaller-actions to control a Virtual Character in a virtual environment to perform virtual-actions, the method comprises steps of: 1) creating the Virtual Character in the virtual environment;2) capturing the motion-capture data of the subject user while the subject user is performing a physical movement; 3) performing the smaller-actions by the subject user while sitting or lying on an operating position;4) enabling the Virtual Character to enlarge the motion-capture data of the subject user to perform virtual-actions, and satisfying the enlarges wouldn't cause the subject user leave away from the operation position. Further an action enlarging system enables the subject user to control the Virtual Character in the virtual environment to do any actions while the subject user need not leave away from the control platform, further enables the subject user in the same operation platform during the operation process and easy to achieve that the subject user-body-parts keep identical with the Virtual Body-Parts of the Virtual Character in the virtual environment, thereby the subject user is easy to operate.

## Description

### TECHNICAL FIELD

The present invention relates to a method for controlling a bionic virtual environment that can enable a man-machine interaction and applications thereof.

### BACKGROUND

Known, technologies give multi-types methods and devices for controlling a bionic virtual environment which can enable a man-machine interaction, but they all have defects: needing big size motion space of user and the motions are limited (only limited number of actions of the Virtual Character are permitted). When the subject users have moved and arrived to a wall, but the actions of the Virtual Character still requires the subject users to keep moving towards the wall, which will lead the subject users to hit the wall. In order to avoid the situation, some existing technologies have to minify the motion space of the Virtual Character (but not the subject users) to realize enabling users to avoid moving or minimizing their movements as far as possible during the controlling process. But thus reduces the game playability and limits the application value of the game. Some known technologies using treadmills to make the subject user play in the same place, but thus technologies also have defects: it is difficult for users to make body movement freely. In addition, it will also increase energy expenditure of the subject user and prevents the subject user from the man-machine interaction for a long time. The known technology for minifying the motion space of the Virtual Character further includes operating moving tools, such as a chariot. The Virtual Character in a virtual environment operates all the process and can only perform the actions for operating the chariot or other similar type of motor device, and can not leave away from the chariot to perform the actions, and limit the body movement of Virtual Character to the limitation of action morphology or action-range. Besides the above described defect, each control on virtual chain is generally required to be associated with a real control, obviously, the traditional way further includes defects of too many controlling elements, high cost, and inconveniently carrying.

### SUMMARY

The object of the present invention is for providing a method and device to enable the subject user to enter into the virtual environment as if the subject user is personally on a scene of the virtual environment. The Virtual Character can perform any action that the subject user want to perform, and the system need not limit the action gesture and action morphology of the actions permitted by the Virtual Character. Simultaneously, the other problems referred in the background are also overcome.

In order to understand the present invention more easily, the term referred in the present invention are explained below.

Virtual Character refers Virtual Characters, controlled by the subject user and taken as the subject user in the virtual environment, is person or any object capable moving.

Smaller-action-plan: can give a command to a computer when the subject user performs one or a set of satisfied smaller-actions. The smaller-action refers the action with small range, such as the moving displacement of any kinetic part/body-parts less than 20 mm within 1 second, for example micro movement of the arm, micro bend of the foot. The above condition especially includes the subject user-body-part do not control or do not completely control the associated Virtual Body-Part of the Virtual Character.

Virtual Action Plan: the virtual environment defines the actions or action plan for the Virtual Character or the prop in the virtual environment, the action plan includes the continuous action combination, the action strength, the action speed, and so on.

User-body-parts: kinetic part/body-parts of user, Not all the subject user-body-part can be used to control the Virtual Body-Part of the Virtual Character especially if the Virtual Character is nonhuman, they do not have some user-body-parts, so the kinetic part/body-parts in the present invention refers some parts on the subject user's body corresponding to the Virtual Body-Part of Virtual Character which defined by the virtual environment. In another aspect, when the number of the Virtual Body-Part of the Virtual Character is larger than the subject user-body-part, other method described in the present invention can be used. Further, the kinetic part/body-parts in the present disclosure are not limited to the junction between the two adjacent bones, any parts such as any point on the upper arm, that can be moved can be taken as the kinetic part/body-parts, such as all upper arm or any point of the upper arm.

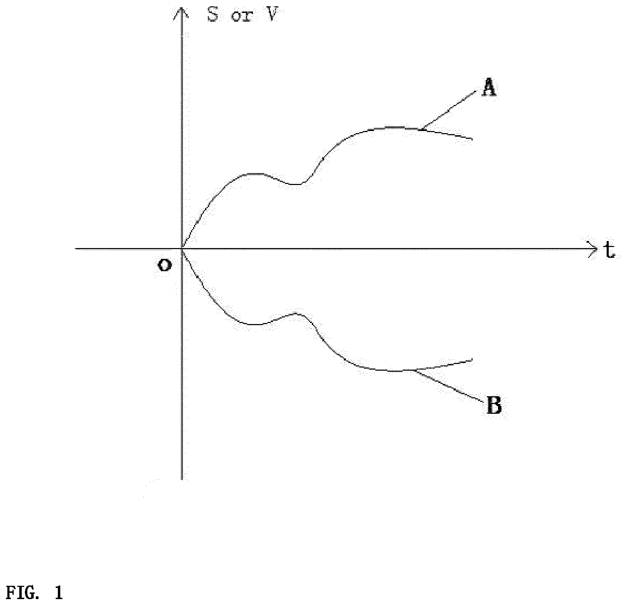

Reverse actions: the virtual environment where the Virtual Character is in performs vector actions which have same vector value and reverse direction with the command given by the subject user, the vector action especially refers to the displacement change and volume change in any time point of the present invention. As shown in FIG.1, if the subject user intend to step or run 5 meters toward southeast direction from time t1 to time t2, the Virtual Character can be controlled to forward 5 meters toward northwest direction during the period t1 to t2. For another example, if the subject user intends his/her body to be enlarged twice proportionally, the scene where the Virtual Character is in is reduced twice. Especially, it should be first determine whether the eyes or a distance between the eyes are includes in the form or shape change command, if the eyes and the distance between the eyes are not changed, the volume of the scene is also not changed, namely, the volume vector action of the scene and the volume vector action of the eyes and the distance between the eyes have the same vector value and reverse direction. The subject user's command is preferably associating the movement vector and vision vector of the head of the Virtual Character wherein, the movement vector can be speed and displacement, the vision vector can be the volume change of the Virtual Character.

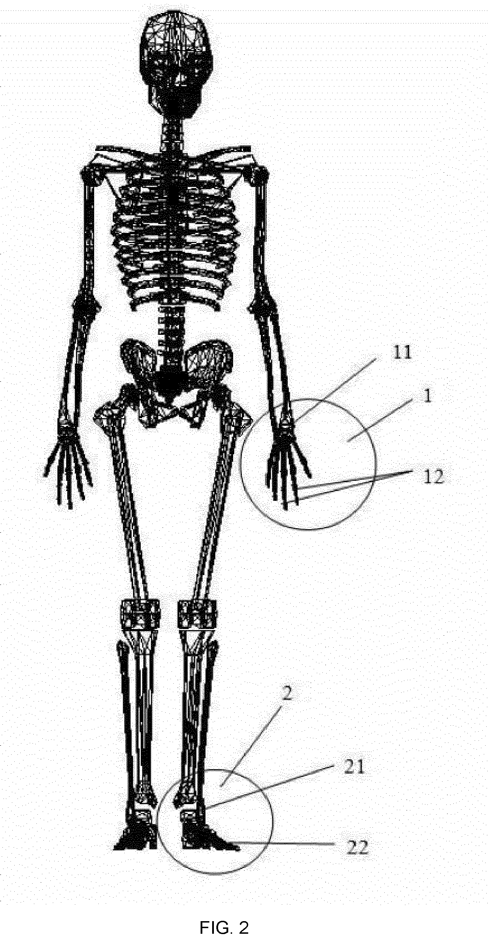

Palm: as shown in FIG. 2, the palm 1 includes the wrist 11 and all the joints of the palm 1, such as fingers 12.

Sole: as shown in FIG. 2, the sole 2 includes the ankle 11 and all the joints of the sole 2, such as toes 22.

The action-range evaluating indicator: this is for evaluating a movement indicator of the traced parts at a certain time point, or a total movement indicator until the certain time point. So the indicator can be the speed of the traced part at the certain time point, and also can be the indicator of the change of the relative position of the traced parts and the other parts at the certain time point, and also can be the total indicator of the change of the relative position of the traced parts and the other parts until the certain time point, such as the changed speed of the angle between the traced part and the adjacent part of the traced part at the certain time point or the angle difference value between he angle between the traced part and the adjacent part of the traced part at the certain time point and a default angle, and further can be the displacement and direction of the tracing part, the angle between the tracing parts in two different time points. The action-range evaluating indicators are not limited the above described examples.

Action enlargement: in order to simulate the real feeling of the subject user and the synchronization requirement during the interaction process, the following two rules are set ( the following two rules are not the necessary rules to achieve the object of the present invention):
1. Within the sensing ability range of the body of the subject user, the action enlargement is preferred to enlarge the action-range and strengths, the action-range evaluating indicator can be the tension range of the muscular of the subject user.
2. Beyond the sensing ability range of the body of the subject user, the action enlargement can enlarge the speed of the action of the subject user.

In order to achieve the above objects, the technology schemes are disclosed below.

1. The Virtual Character can perform any actions which the subject user requires and the system need not limit the gesture and type of the action permitted by the Virtual Character.

The technology scheme of the present invention includes the following steps of:
1) creating the Virtual Character in the virtual environment to make the Virtual Character have more than one Virtual Body-Part;
2) associating user-body-parts with the Virtual Body-Parts of the Virtual Character determining enlarging proportions of an action-range of different Virtual Body-Parts relative to the action-range of the subject user-body-parts, permitting gestures of the two adjacent user-body-parts are different from gestures of the associating Virtual Body-Part of the Virtual Character further permitting movement morphology of the subject user and the Virtual Character is different and not similar, further satisfying the Virtual Character is not lying or sitting in a movement process while the subject user is lying or sitting on the operation position and need not leave away from the operation position;
3) performing the smaller-actions by user sitting or lying on an operating position;
4) enabling the Virtual Character to perform virtual-actions which enlarge the motion-capture data of the subject user, and satisfying the action enlargement wouldn't cause the subject user leaving away from the operation position.

Particularly, the enlarging proportions that the smaller-action of the different parts of the subject user is enlarged can be different, especially to the two different parts whose enlarging proportion is not 1, the enlarging proportions of them can be different, for example, the enlarging proportions of the fingers is 3 at a certain time, but the enlarging proportions of the upper arm is 20 at the same time. The enlarging proportions of the same kinetic part/body-parts at different times can also be different.

### Preferable scheme 1:

A maximum range value M is set for each of the smaller-actions which are performed by of the subject user or a prop, a maximum range value N is set for the virtual-actions which are performed by the Virtual Character the N is less than a movement limit of the corresponding kinetic part/body-part of the subject user, supposing the action-range of the smaller-action permitted by the subject user in time t is Mt, the action-range of the virtual permission action performed by the Virtual Character is Nt, then if Mt≥M, Nt=N; if Mt<M,N>Nt>Mt. For example, if user's arm is lift 5 degrees, the Virtual Character lift the arm completely, if user's arm is lift beyond 5 degrees, the Virtual Character also lift the arm completely, so the 5 degree is taken as the maximum range value to lift the arm, obviously, the subject user's arm can lift more than 5 degrees.

Particularly, when user performs one smaller-action, the actual movement limitation of the user is larger than the maximum range of the smaller-action. In order to achieve the technology effect more effectively, when the virtual environment uses the action enlarging system, it is better to limit the limbs of the subject user perform smaller-actions.

The subject user permitted smaller-action-plan satisfies: when the subject user finishes one smaller-action with the maximum range M, the angle change of any two adjacent parts of user' s body, excepting palm and sole, is less than 30°. For example, one smaller-action-plan relates to the angle of the upper arm and the lower arm, the angle before performing the action is 120°, and the angle after performing the action is 140°, then the angle change of the upper arm and the lower arm is +20°. Obviously, the action morphology (or gesture) of the subject user and the Virtual Character is not required to be the same or similar (the same gesture refers the Virtual Character and the subject user have same gestures at a certain time; the similar gesture: the Virtual Character and the subject user have different gestures at a certain time, the gestures include at least sitting or stand, the action morphology refers to moving while lying, moving while sitting, moving while walking; the moving morphology of the subject user and the Virtual Character are not similar refers that the subject user is moving while lying but the Virtual Character is moving while walking).

Additionally, the present invention provides continuous action commands, when the subject user acts to an elastic device continuously, the subject user can keep the actions such as turning around. Therefore, the subject user can control the Virtual Character to do any action under any gesture. The maximum action-range M of the present invention is preferably within negative and positive 5^{o}.

Particularly, the enlarging proportions that the smaller-action of the different body-parts of the subject user is enlarged can be different, especially to the two different body-parts whose enlarging proportion is not 1, the enlarging proportions of them can be different, the enlarging proportions of the same kinetic part/body-parts at different times can also be different.

### Preferable scheme 2:

1. Limiting the movement range of user's limbs and enabling the limited body-parts can perform the smaller-action completely while the body of the subject user does not leave away from the operation position, the limited scheme also can be optimized by one or more optimization schemes:
   1) the user-body-parts is acted according to the action characters of the object when any object in the virtual environment acts to certain or some parts of Virtual Character;
   2) determining the reaction user-body-parts and effect acted to the Virtual Character to make the corresponding acted user-body-parts is proportional to the determined reaction effect according to the action characters and the instantaneous state of the Virtual Character when the Virtual Character acts to any object in the virtual environment;
   3) making the corresponding parts of the subject user to be acted with a certain proportion load that the subject user is able to receive according to the physical fatigue degree or the biggest motion ability of the Virtual Character.
2. The method for the virtual environment to receive the commands of the subject user:
   The method captures the actions of the subject user by a smaller-action recognizing system, and recognizes the command content given by the subject user by associated actions between the subject user and the Virtual Character, thereby controls the action of the Virtual Body-Parts of the Virtual Character.
   The smaller-action recognizing system sets one or more than one position sensing element on the subject user's body or props, and captures the gesture or action change of the subject user in any time according to the change of the position of the position sensing element with the time change.
   A "method for determining position change of the position sensing element", a "method for controlling a Virtual Character to act by position change of position sensing elements", and a "method for corresponding position sensing elements or the change thereof with the Virtual Body-Parts of the Virtual Character" related to the present invention are described below in turn.
   The method for determining position change of the position sensing element includes the steps of:
   1) establishing a virtual three-dimensional coordinates, and determines the coordinates of the three or more than three distance measurement points which are not on the same straight line in a coordinate system;
   2) measuring the distance between the position sensing elements and each of the distance measurement points, and then computing the three-dimensional coordinates of each of the position sensing elements at any time;
   the method for controlling a Virtual Character to act by position change of position sensing elements is provided for the N Virtual Body-Parts of the Virtual Character such as A1, A2, ...An, which are defined by the virtual environment, the method controls the Virtual Character in the following situation;
   1) if each of the N kinetic part/body-parts can correspond to one kinetic part/body-parts on the subject user's body, setting N position sensing elements, such as N1, N2...Nn on corresponding user-body-parts, tracing the 3D position change of each of the position sensing elements at any time, controlling the Virtual Body-Parts of the Virtual Character to perform actions;
   2) if not all the N kinetic part/body-parts can find the corresponding kinetic part/body-parts on the subject user's body, supposing there are several Virtual Body-Parts Mx which can not correspond to the subject user-body-parts, enabling the kinetic part/body-parts Nx of the subject user to control S Virtual Body-Parts of the Virtual Character such as Mx1, Mx2, ...Mxn, and using one or all of the selecting method and the combination method to select the controlled Virtual Body-Parts Mx. The selecting method refers to after the kinetic part/body-parts determines the corresponding Virtual Body-Parts, the kinetic part/body-parts can control the Virtual Body-Parts separately. The combination method refers when the Virtual Body-Parts is required to replace, using one command or other kinetic part/body-parts Z together to correspond the different Virtual Body-Part Mx again, for example, the arms of the subject user can select the arms and wings of the Virtual Character to control, if the kinetic part/body-part is the joint of toe, when the toe is curled, the wing is controlled, the one command refers to when the subject users gives a command satisfy the requirement, the system will pops up a selecting window and user can displace or determine the corresponding Virtual Body-Parts.
3. The invention further incudes one or more of a olfactory system, a tactile system, a physical fatigue random obstacle system..
   When the system recognize that the Virtual Character is more tired, the load that the obstacle mechanism act to the corresponding parts is more larger, and the subject user performs the action more difficultly, and the play is more realistic.
4. The present invention further provides a wearable controlling device fit for the virtual environment.
   The wearable controlling device includes palm sets, arm sets, head sets, sole sets, leg sets, buttock sets, and waist set. Each of the above sets one or more than one sensing positioning points.
   The wearable controlling device further needs to satisfy the following requirements: setting one or more than one sensing positioning points on the three joints of each fingers, the joints of wrists, the joints of elbows, the joints of shoulders, any three points on the head which are not on one straight line, one joint of each toe, joints of ankles, and center of calf, thigh, and a spine.
   The device aims at determining the position and gesture of the subject user at any time point according to the position of the sensing position points setting on the subject user's body.
5. The invention provides a method for the subject user to see his/her body entering a virtual environment.

A positioning system, a panoramic system, and a scene moving system are used together to achieve the method.
1. The scene moving system uses the reversible actions of the scene where the Virtual Character of the virtual environment is stayed to make the subject user has an illusion that his/her body is moving or changing (enlarging/reducing the body or varying shape of body). The method for determining the scene wherein the Virtual Character is in includes:
   1) directly fixing positioning element, which can be moved simultaneously with a head, on the head of the subject user, the positioning element defines three position sensing elements that are not on a same straight line, the positions of the position sensing elements can be determined in the virtual environment, and thereby, the position and facial direction that the face towards of the head in the virtual environment;
   2) determining the images of the virtual environment according to the position and facial direction of the head in the virtual environment.
2. The panoramic system refers to: in the virtual environment, the images of the virtual environment cover all the vision range of the subject user, and the subject user only can see the scene of the virtual environment and can not see the scene in the real world. Particularly, the system refers that the subject user wears a 3D glasses, and the screen of the glasses and the images of the virtual environment cover all the vision range of the subject user.
3. The positioning system satisfies that the imaging position of the Virtual Character in the subject user's eyes is the same as the position where the subject user stays, and the movement of the subject user's body is synchronizing with the movement of the Virtual Character when the subject user what to see his/her body, he/she can see the actions he/she acts in the virtual environment.

### The advantage of the above technology schemes

If the subject user performs the smaller-actions, the invention can control the Virtual Character to enlarge the smaller-action, and the enlarging proportion can be different, namely the instantaneous gesture of the subject user is different from that of the Virtual Character, and the gesture change situations of the subject user and the Virtual Character are also not quite equivalent. Thus greatly relax the operation space requirement of the subject user, namely, "the contact parts of the Virtual Character and the virtual environment" and the "contact parts of the subject user and the operation space" can be different. Especially, the "the subject user's parts supported by the operation position" and "the Virtual Character's parts supported by the virtual environment" can be different, for example, when the subject user sits on the operation position to control the Virtual Character to perform the step action, "the subject user's parts supported by the operation position" is a buttock of the subject user, but the "the Virtual Character's parts supported by the virtual environment" is a sole of the Virtual Character.

Simultaneously, "the force that the subject user acts to the operation position" can be different from "the force that the Virtual Character acts to the virtual environment". When the Virtual Character perform one action to act force to the virtual environment, thereby to make the Virtual Character generates displacement, the subject user does not act the force to the environment where the subject user stays, or the operation force for controlling the operation platform is not enough to overcome the limitation of the operation platform to the subject user's body. Therefore, no matter how many displacements the Virtual Character generates, the subject user can control the Virtual Character while not leaving away the operation platform. For example, if the subject user sits on the bed to control the Virtual Character to step, the subject user only needs to slightly incline the upper body and swing the two feet on the bed, these actions cannot change the position of the subject user on the bed.

Because when the Virtual Character do any movement and the generates any displacement in the virtual environment, the user does not need to leave the operation position, the system need not limit the movement space and movement form to satisfy the requirement of operation space to the subject user's body (supposing the system opens the limitation to the movement space and movement form of the Virtual Character the situation that the subject user leaves away from the platform or impacts the wall is easy to happen if the traditional technology is used, the situation that the subject user leaves away from the platform or impacts the wall will not happen if the technology of the present technology is used).

Because the subject user need not leave away from the operation position, the system can control the Virtual Character to perform any actions while need not limit the type, number, and range of the action. Further, during the operation process, the subject user can lying or sitting, therefore, the subject user can freely operate the Virtual Character for a long time, and the operation can not be stopped because of fatigue. The system of the invention fit for different types of people, any people capable of moving can perform the man-machine interaction by the technology disclosed in the present invention.

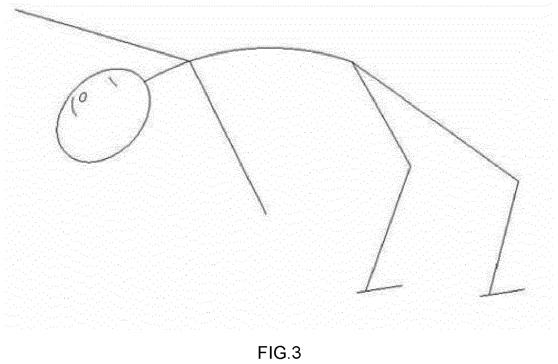

Due to the subject user controls the Virtual Character by the smaller-action, the Virtual Character can perform the actions which can not be performed in the really environment, for example, the subject user can control the Virtual Character perform a back bend action as shown in FIG. 3 while performing a punch action.

The "action enlarging system" disclosed in the present invention enable the subject user control the Virtual Character in the virtual environment to do any actions while the subject user need not leave away from the control platform or move a little distance, further enables the subject user does the operation in the same operation platform during the operation process and easy to achieve that the subject user-body-parts keep identical with the Virtual Body-Parts of the Virtual Character in the virtual environment, thereby the subject user is easy to operate.

The "selecting method" and "combination method" of the present invention can achieve the number of Virtual Body-Parts of Virtual Character is bigger than the number of the position sensing points, for example, the disabled person can control the parts of Virtual Character which the disabled person lost to move freely.

Further description of the invention is described below in conjunction with the company drawings and the specific embodiment.

### BRIEF DESCRIPTION OF THE DRAWINGS

FIG. 1 is a vector action time diagram of a same vector action of the scene where the Virtual Character stays and the head of the Virtual Character in the virtual environment, wherein t represent time, V represents volume, S represents displacement, a curved line A is a time diagram of the volume vector action or the displacement of the scene where the Virtual Character stays; a curved line B is a time diagram of the volume vector action or the displacement of the head of the Virtual Character. A top view of a mixed mode filter (without cover) in accordance with an embodiment.
FIG. 2 is schematic diagram of joints of a user.
FIG. 3 is a schematic diagram of virtual-actions.

### DESCRIPTION OF THE EMBODIMENTS

### A first embodiment, a method for controlling man-machine interaction

The method for controlling man-machine interaction establishes a user smaller-action database and a Virtual Character virtual action database, and provides action enlarging rules and man-machine interaction rules.

The user-smaller-action database further includes a user-smaller-action-plan database.

### 1. the user-smaller-action database:

1.1) Establishing database based on keywords of a head, a neck, a wrist, upper arm, a lower arm, a hip, a upper leg, a lower leg, a palm, and a sole to determine motion part/body part of Virtual Character action capable controlled on a user's body;
1.2) Defining description parameters of the kinetic part/body-part, including displacements, angle varying values of adjacent parts, and moving speeds, to rule the form of commands given by the kinetic part/body-parts;
1.3) Defining upper limit of the description parameters, determining upper limit of smaller-action-range to ensure user can continuously perform any controlling actions without leaving a controlling position.

### 2. the user-smaller-action-plan database:

2.1) Ruling situations not giving commands;
2.2) Ruling conditions for giving stunts, namely when user acts qualified action or action group, the Virtual Character performs stunts action, especially referring opening authority of ruling the conditions to make different users rule the conditions according to their personalities.

### 3. The virtual action database

3.1) corresponding to user's kinetic part/body-parts rules the Virtual Body-Parts of the Virtual Character;
3.2) action parameters of Virtual Body-Parts: displacement, speed, strength; for determining enlarging proportions of the action-range of the virtual action of the part to the action-range of the action of the kinetic part/body-part of the subject user.

### 4. man-machine interaction rules

Associating the user-smaller-action database and the virtual action database based on the following relation:
4.1) the user-body-parts of smaller-action database associates the Virtual Body-Part of The virtual action database;
4.2) the description parameters of the user-body-part of the user-smaller-action database associates the action parameters of Virtual Body-Parts of The virtual action database.

### 5. action enlarging rules

5.1) Limiting article 4.1) of the man-machine interaction rules according to the "upper limit of the description parameters" defined in the user-smaller-action database.

5.2) setting the largest action-range of any permission action performed by the subject user or the virtual props is M, setting the largest action-range of corresponding permission action performed by the person or object in the corresponding virtual environment is N, setting the action-range of the permission action performed by the subject user or the virtual props at the time point is Mt, setting the action-range of corresponding permission action performed by the person or object in the virtual environment is Nt, thereby the system satisfy: if Mt≥M, then Nt=N; if Mt<M, then N>Nt>Mt.

**6. In order to ensure synchronization of the man-machine interaction, the embodiment further provides a man-machine synchronization system.** The man-machine synchronization system includes a user smaller-action recognizing system and a smaller-action matching commands ruling system.

6.1) the user smaller-action recognizing system rules the kinetic part/body-parts and un-kinetic part/un-body-parts on the subject user body or props and setting position sensing elements including distinct characters on the different kinetic part/body-parts respectively, establishing a virtual three-dimensional coordinates, and fixes a distance measurement device on three or more than three known coordinate points which are not on the same straight line, the three or more than three known coordinate points fixed distance measurement device are distance measurement points. The particular method refers to the following description:
a) measuring the distances between the position sensing elements and each of the distance measurement points at any time, and then computing the three-dimensional coordinates of each of the position sensing elements;
b) determining the gesture of the subject user at any time point to the change of the action in a certain period by capturing the position change of each of the position sensing elements with the time point change.

The smaller-action recognizing system of the embodiment is aimed at tracing the movements of the limbs , torso and head of the subject user in a real time point and also can set two or more than two position sensing elements on any user-body-part, wherein the coordinates of at least two points set position sensing element on the x, y, and z axis are all different, and thus the horizontal rotation angle and vertical rotation angel of user-body-parts in a certain period can be determined.

6.2) the smaller-action matching commands ruling system: makes the sensing positioning point on the body generate a displacement change which based on a predetermined rule by controlling body action of the subject user, and thereby matching the Virtual Action Plan of the Virtual Character it includes

### A rule 1:

The rule 1 includes "a method for controlling a Virtual Character to act by position change of position sensing elements" and " a method for positioning sensor or its change corresponding to virtual body-part or virtual-action of the Virtual Character"

A rule 1.1 a method for controlling a Virtual Character to act by position change of position sensing elements.

Defining N separating kinetic Virtual Body-parts, such as A1, A2, ...An, for the Virtual Character in the virtual environment, and defining m types of virtual- action, such as Ax1, Ax2, Axn, for any one, such as Ax, of the N separating kinetic Virtual Body-parts, Axx is any one of the m types of virtual-action and can be controlled according the two situations described below.

The first situation, namely each of the N kinetic Virtual Body-parts of the Virtual Character can correspond to one kinetic user-body-part on the subject user.

1) corresponding to n sensing positioning point A', such as A1', A2', ...An', to n separating user-body-parts, tracing the 3-D position change of any one, such as Ax', of the n sensing positioning point A' in any time point t, and matching one of smaller-motion plans Ax1' Ax2', ...Axm', wherein Axm is any motion plan of m Virtual Action Plans.

2) making each of the separating Virtual Body-parts of the Virtual Character correspond to one of the sensing position point A' on the user's body, the Virtual Action Plan Axx of any one of the separating Virtual Body-part Ax is started only when the sensing positioning point Ax' on the user- body-part acts by the smaller-action plan Axx', for example, the displacement change of the Ax changing with the time point change corresponds to the displacement change of the Ax' changing with the time point change, for another example, the strength of the Ax corresponds to the bending degree and jiggling frequency of the joints, the condition for the strength of the Ax reaching to the maximal value is that the range of the Ax' of the subject user reaches to a maximal value; in addition, the Ax further should consider the tension degree, movement rapid, and performing time point of the corresponding Ax' to realize to operate the virtual environment more naturally and make the movement of the Virtual Character comply the law of nature.

3) the user-body-part of the present embodiment are aimed at determining the position and gesture of the subject user in any time point according to the sensing positioning points setting on the subject user's body. The user-body-part satisfy this aim are taken as example, such as three joints of each fingers, joints of wrists, joints of elbows, joints of shoulders, any three points on the head which are not on one straight line, one joint of each toe, joints of ankles, and center of calf, thighs, and a spine.

The second situation, namely when not all the N kinetic Virtual Body-parts can find the corresponding kinetic user-body-part.

Supposing there are several Virtual Body-parts Ay can not find corresponding user-body-part, first, enabling the user-body-part Ay' to control s Virtual Body-parts such as Ay1, Ay2, Ays, and further selects the controlled kinetic Virtual Body-part Ay through one of a selecting method and a combination method. The selecting method refers to after the kinetic user-body-parts Ay' determines the corresponding Virtual Body-Parts Ay, the kinetic user-body-parts Ay' can control the Virtual Body-Parts Ay separately. The combination method refers selecting the different user-body-part to control using one command or other user-body-part when the Virtual Body-part needs to be changed, for example, the arms of the subject user can select the arms and wings of the Virtual Character to control, if the user-body-part is the joint of toe, when the toe is curled, the wing is controlled, the one command refers to when the subject users gives a command satisfy the requirement, the system will pops up a selecting window and user can displace or determine the corresponding Virtual Body-Parts.

In addition, the method for controlling a Virtual Character to act by position change of position sensing elements further includes dividing the parts of the subject user's body and the prop to kinetic parts and stationary parts, and setting position sensing elements to the kinetic parts respectively, wherein, the props correspond to the objects or tools in the virtual environment, and thereby, when the props is operated, the objects or tools in the virtual environment can also be operated, that is to say, the position sensing elements are used to control the things (persons or objects) in the virtual environment.

A rule 1.2, a method for positioning sensor or its change corresponding to virtual body-part or virtual-action of the Virtual Character:
setting different distinctive characters for the position sensing elements fixed on the different user-body-part, and corresponding different distinctive characters to the Virtual Body-parts or different virtual-action of the Virtual Character;
the distinctive characters are the different density or rules of painted points disposed on the position sensing elements; if the position of the position sensing element, the density of the painted point on which is d and/or the rules of the painted points on which is rule 1, is changed, certain Virtual Body-part of the Virtual Character performs the corresponding virtual-action. The density and rules of the painted point can be achieved by stamping.

### A rule 2: a rule for not giving command

The rule in the present embodiment is preferably the rule for not giving command, but the rule for giving command is also included in the embodiment.

The sensing position points of the embodiment adapted to the following two method.

1) taking the paint which can be detected as the sensing position points and painting the sensing position points on the sensitive point on the muscle, obtaining the tension range of muscle and moving speed of the user-body-parts by analyzing the movement state and the position change of the position sensing elements, and thereby concluding the intend of the subject user according to a fine adjusting mechanism and then giving command to the things in the virtual environment.

2) Fixing the sensing position points on the user-body-parts of the wearable controlling device, after the subject user wears the device, the actions of the parts of the body can control the sensing position point generates corresponding command, thereby, the subject user can see the actions of himself/herself or the tools operated by himself/herself in the virtual environment. The wearable controlling device can shortage the preparing time point before the subject user enters into the virtual environment and simplify the preparing process, and therefore the subject user can enter into the virtual environment more conveniently.

The above two methods are not limited to applied to an action enlarging system, and especially adapted to the virtual environment play which does not requiring displacement of the subject user's body, such as car racing virtual environment.

In the embodiment, the wearable controlling device further can be implanted a controller to make an operating unit including in the wearable controlling device sense the vector change (e.g. displacement, speed, direction) generated by the sensing position points. By combining with a sensing positioning points system, the wearable controlling device can be simplified, and only needs mechanism construction and does not need to be provided with the electronic system. Because the subject user's body only performs the smaller-actions in the virtual environment, the wearable device almost no damage, thus extends the service life of the device while avoiding to the use's body hurt caused by the short-circuit of the electronic system.

In the embodiment, the wearable controlling device includes palm sets, arm sets, head sets, sole sets, leg sets, buttock sets, and waist set. Each of the above sets one or more than one sensing positioning points.

The device further needs to satisfy the following requirements: setting one or more than one sensing positioning points on the three joints of each fingers, the joints of wrists, the joints of elbows, the joints of shoulders, any three points on the head which are not on one straight line, one joint of each toe, joints of ankles, and center of calf, thigh, and a spine.

The device aims at determining the position and gesture of the subject user at any time point according to the position of the sensing position points setting on the user-body-parts(the subject user's body).

The arrangement of the sensing position point of the device is not limited to the above described arrangement.

**7. For improving the bionic effect, the embodiment further provides a man-machine interaction system.** The system includes a reaction sensing device and an action sensing device. The system is mainly used to correct a ratio Mm/Nm of a user's maximum permitted smaller-action-range Mm to the Virtual Character's maximum permitted smaller-action-range Nm, and make the ratio Mm/Nm is bigger than a default value, namely when the reaction sensing device and the action sensing device is working, Virtual Character's maximum permitted smaller-action-range Nm is reduced proportionally according to the following reasons.

7.1) If the man-machine interaction is triggered by the Virtual Character it is performed by the following method:
7.1.1) Focusing on the object which the subject user intents to act;

### A first method

Using a user's eyes positioning device to focus the object which the subject user intents to operate, specifically, when the gaze direction of the user passes through an object and the action direction of the limb or prop directs to the object, the eyes positioning device gives a command that the limb or prop will act to the object, and then the system sends the command to the Virtual Character to focus on the objet. Wherein, the technology for tracing user's gaze can use the technology disclosed in a patent application file numbered CN 201110411809.X and titled "method for recognizing the gaze direction during user looking an object", or any other known technology, such as a patent file numbered CN 02829315.0 and titled " tracing the direction and position of rolling eyes".

### A second method

Using an eyes image capturing device to determine the main object which the subject user focuses on, wherein the eyes image capturing device can use the known technology such as a patent file numbered CN 200610072961.9 and titled "eyes image capturing device".

7.1.2) After the action is acted to the focused object, the movement speed and movement range of the Virtual Character must be changed because of the reaction acting on the Virtual Character The system adjusts the acted loads by the reaction sensing device, or changes the virtual maximum range of the corresponding parts, or changes the enlarging proportions of the actions of the Virtual Body-Parts to the user-body-parts to make the subject user to feel the change of the "action speed" and "action-range" after the Virtual Character acts to one object.

7.1.3) Computing the morphology change of the acted object after the action is acted to the focused object, the morphology change includes a shape change (e.g. gesture change, shape change that can not be recovered, especially refers to damage), and a kinetic energy change (kinetic energy value + kinetic energy direction).

7.2) In the man-machine interaction process, when the other object of the virtual environment acts to the Virtual Character to make the Virtual Character interact passively, the following step are performed:

7.2.1) automatically focusing on the acting object when the Virtual Character is acted to generate an action effect;

7.2.2) the Virtual Character is acted to generate an action effect refers to the morphology change of the Virtual Character after the action is acted to the Virtual Character the action effect is feed back to the subject user by the reaction sensing device, or changes the virtual maximum range of the corresponding parts to make the subject user to see the effect of the Virtual Character and thereby generates illusions alike or similar to the reaction sensing device by the vision.

### Taking an example to describe

If the Virtual Character intends to attack a game character, first the attacked object should be focused, when the Virtual Character gives a punch to the moving arm of the attacked object, the reaction of the arms of the attacked object is received. Particularly, no matter whether the attacked object blocks, based on the action and reaction principle, if the Virtual Character touch the attacked object, the Virtual Character certainly receives the reaction. If the attacked object blocks, the Virtual Character receives the action of the blocking arms of the attacked object, and then the effect of the reaction sensing device is added.

### Particularly it should be referred:

1) For ensuring the efficiency of the action enlarging system, the performed condition of the virtual-action of the Virtual Character is not the position of the sensing positioning point at a certain time point, but the position change relative to the previous time point.
2) the position of the distance measurement points are fixed or the coordinates of the distance measurement points can be determined by computing;
3) In some virtual environment, in order to reduce the occupancy of the computer resource, a few of particular actions are defined for the Virtual Character in such situation, the action or combination action of some parts of the subject user can control the Virtual Character to do a successive virtual-action.
4) The action enlargement system and an action positioning point controlling system can be used together or used separately.
5) The invention further includes a voice controlling system which enable the subject user give commands by the voice to control the virtual-actions of the Virtual Character and the basic operations of the virtual environment, such as, exiting, saving. The system further includes voice recognizing system for recording user's voices and matching commands for the recorded user's voices.

### Other specification:

After ready, the subject user will find the position where he/she exit the virtual environment last time and this position is taken as the start position for the scene change caused by the following actions.

The virtual environment permits the Virtual Character has deformation ability. After the Virtual Character is deformed, if the number of the controlled parts of the Virtual Character is greater than the number of the user-body-parts, the "selecting method" can be used. When a selecting commands action is acted, a certain user-body-part is selected to control the kinetic Virtual Body-parts of the Virtual Character in the virtual environment. Further, the "combination method" also can be used, namely, when the two or more than two user-body-parts performs a particular action simultaneously, the same effect can be achieved.

The virtual environment further permits the subject user has super abilities such as telekinesis. The starting condition for giving such command is the sensing positioning points on user's arm are all on a straight line, the sensing positioning points on the palm are forms a ungual shape and extend toward the object, determining the attraction power in the virtual environment needs to predefine the maximum value of the attraction power of the Virtual Character first. The condition for predefining the maximum value of the attraction power is the jiggling frequency of the fingers. The attraction power is reduced with the reduction of the jiggling frequency.

When receiving the intend of the subject user, the virtual environment will computing attraction power and comparing the difficulty to attract the object, if the gravity of the object is too great or the attraction power between the object and the place where the object place is too great, the strength of the clutch action should be added, thereby the curved degree of the finger is more greater, and the jiggling of the fingers is strengthened, thus causes the jiggling of the sensing positioning point on the fingers are strengthened, thereby the computer can receive the information about that the attraction power of the subject user is strengthened, and further can determine whether the attraction of the object is completed.

The way for corresponding the position sensing elements and the parts that the position sensing elements controlled. If each of the user-body-parts corresponds to one position sensing elements, in the virtual environment with a great number of virtual-actions, the subject user should prepare for a long time to enter into the virtual environment. For this reason, the invention provides the wearable controlling device. Only needing wears the gloves, foot sets, supporter sets and headset, the subject user can controls the sensing position points covered on each of the joint, therefore, the wearable controlling device is more practice.

Because the action enlarged method is used, the body of the subject user does not corresponds to the limbs position and gesture of the Virtual Character therefore, it can not be determined by the position of the sensing positioning points alone, but the position and direction of the head (especially the eyes) of the subject user and the virtual character is the same. Then how to explain the coordinates of the subject user can be determined in the virtual environment? First, the vision of the subject user is obtained by the glasses, so the coordinates of the glasses in the virtual environment can be determined. Because the relative position between the eyeball and the glasses is invariable, the coordinates of the eyeball of the subject user in the virtual environment can be determined..

### A second embodiment, a virtual device

The virtual device includes a positioning system, a panoramic system, a scene moving system, action concluding system, and action enlarging system.

A. The action concluding system: the known technology, such as patent application file numbered 97198214.7, can be used.

B. The action enlarging system: referring to the detailed description in the first embodiment.

### C. The panoramic system

The panoramic system refers to in the virtual environment, the images of the virtual environment cover all the vision range of the subject user, and the subject user only can see the scene of the virtual environment and can not see the scene in the real world. Particularly, the system refers that the subject user wears a 3D glasses, and the screen of the glasses and the images of the virtual environment cover all the vision range of the subject user. This technology can refer to the known technologies, such as a Chinese patent file numbered CN 200810066897.2 and titled "mobile video glasses integrated CMMB receiving module".

### D. The positioning system

The positioning system satisfies that the imaging position of the Virtual Character in the subject user's eyes is the same as the position where the subject user stays, and the movement of the subject user's body is synchronizing with the movement of the Virtual Character thereby, when seeing the body of the Virtual Character the subject user may have an illusion that the body of the Virtual Character is the real body of himself/or herself. The method for synchronizing the movement of the subject user's body and the movement of the Virtual Character's body determines the action of the subject user by the action recognizing system, determines the content of command given by the subject user, and then controls the movement of the kinetic part/body-parts of the Virtual Character.

### E. The scene moving system

The scene moving system using the reversible actions of the scene where the Virtual Character of the virtual environment is in to make the subject user has an illusion that his/her body is moving or changing (enlarging/reducing the body or varying shape of body). The method for determining the scene wherein the Virtual Character is in includes:
1) directly fixing positioning element, which can be moved simultaneously with a head, on the head of the subject user, the positioning element defines three position sensing elements that are not on a same straight line, the positions of the position sensing elements can be determined in the virtual environment, and thereby, the position and facial direction that the face towards of the head in the virtual environment;
2) determining the images of the virtual environment according to the position and facial direction of the head in the virtual environment.

The fixed position of the positioning element on the head should satisfy the requirement that the positioning element must move simultaneously with the movement of the head, further, the positioning element also can fixed on the tools wear on user's head.

In the embodiment, the synchronization relation used in the face of the subject user and the Virtual Character can also use the action enlargement system..

In the embodiment, in order to make the virtual environment more lifelike, the device further includes one or more of a olfactory system, a tactile system, a physical fatigue random obstacle system .

The physical fatigue random obstacle system can combine with wearable controlling device, such as connecting a push mechanism to the sole set, or placing a hand-held tool inside the palm set.

The obstacle system includes a reaction sensing device and an action sensing device. The action sensing device is required: when any object in the virtual environment acts to one or some parts of the Virtual Character the obstacle system acts to the corresponding parts of the subject user according to the characters of the action of the object. The reaction sensing device is required: when the Virtual Character acts to any object of the virtual environment, the obstacle system concludes the reaction parts and reaction effect to the Virtual Character according to the action characters and the state at that time of the object, and the obstacle system acts to the corresponding parts of the subject user proportionally. The obstacle system changes the load which the reaction sensing device and the action sensing device put on the subject user according to the physical fatigue degree or the biggest motion ability of the Virtual Character.

### Referring an example for further description

Before simulating the virtual environment, the subject user should be fixed on a operation position (e.g. bed), when user move any limb on the body, the Virtual Character in the virtual environment performs an action. Thus arrangement is aimed that user can operate the Virtual Character in the virtual environment at the same operation position when acting any action. After acting, the position where the body stays does not change, thereby reducing movement space of the subject user.

The subject user is lying on or sitting on an operation platform, the obstacle system limits the biggest movement range of the limbs of the use's body, such as a sole device elastically contacting the foot of the subject user, an arm limited device is put around the arm of the subject user by the way of interference fit.

The obstacle mechanism is place on the parts of the body of the action permitted by the subject user, in the common situation, the obstacle mechanism keeps a certain distance (called free space) from the subject user's body to enable the parts of the subject user's body to do any smaller-action without effect of the obstacle mechanism in the situation that the parts of user's body do not contact the obstacle mechanism. The obstacle mechanism defines an elastic load moving area (called load space). When the subject user's body contacts the obstacle mechanism and goes on moving to the direction of the elastic force, the corresponding parts of the body work by overcoming the elastic force. The functions of the obstacle mechanism are:
1) the sum of the movements of the free space and the load space corresponds to the biggest range of the smaller-action of the subject user;
2) when the body of the subject user acts to the obstacle mechanism and the action of the body fit for the command capable recognizing by the computer, the Virtual Character performs the virtual-action continuously, such as turning around continuously;
3) if the man-machine interaction is caused by the subject user, the obstacle mechanism does an reaction to the subject user;
4) if the objects in the virtual environment acts to the Virtual Character of the virtual environment, the obstacle mechanism reduces the free space and acts to the body of the subject user;
5) if the movement ability value of the Virtual Character is improved, the load of the obstacle mechanism is reduced;
6) if the movement ability value of the Virtual Character is reduced, such as fatigue, the load of the obstacle mechanism is improved;

The video device of the invention is not limited to the device obtained image by the eyes, the patent file numbered CN 00820024.6 and titled " implanting element implanted to the human body and a manual optical system discloses a method for enabling the brain to obtain the images not by the eyes.

### The third embodiment, a playing method is provided.

A playing method provides the super ability to the Virtual Character includes the steps of:
1) creating the virtual-actions of super ability of the Virtual Character excepting the ability for enlarging the stamina of the subject user.
2) capturing the change of the smaller-action of the subject user and determining the acted object of the virtual permission action of super ability of the Virtual Character.
3) Evaluating the evaluation indicators of the super ability of the Virtual Character during performing the virtual permission action of the super ability to make the acted object generate morphology angel proportionally.

The morphology angel of the Virtual Character includes position, shape, state, and matter, wherein the shape includes shape change, change between the liquid state and the granulation state, state change includes: change among the gas state, liquid state, and solid state, and position change includes: change of displacement, movement speed, and acceleration.

The virtual environment of the present invention at least includes one or more of a future environment, a past environment, and dream environment.

The present invention opens the authority to the subject user to reset the parameters of the object in the virtual environment, thus enables the subject user to establish, adjust, delete the virtual environment, and thereby, the subject user can easily realize the virtual object. The present invention far surpasses the traditionally tools.

**The fourth embodiment, a man-machine controlling method which is applied to the exhibition and communication of the space design and space sample,** includes the steps of:
1) modeling 3D model for the space design and space sample;
2) enabling the subject user to use the man-machine interaction controlling method of the first embodiment to control the Virtual Character to perform the virtual actions in the 3D model modeled for the space design and space sample.

**The fifth embodiment, a man-machine controlling method, which is applied to shoot a movie,** includes the steps of:
1) modeling a 3D model for movie scenes
2) enabling the actors to use the man-machine interaction controlling method of the first embodiment to control the Virtual Character to perform the virtual actions in the 3D model modeled in the step 1);
3) recording the required scenes in the 3D model and the images of the virtual actions performed by the Virtual Character.

**The sixth embodiment, a man-machine controlling method, which is applied to simulate an experiment,** includes the steps of:
1) collecting the known laws of nature and establishing algorithm f[x1(x11, x12...x1n), x2 (x21, x22...x2n)...xn(xn1, xn2...xnn)]= y1(y11, y12...y1n), y2 (y21, y22...y2n)...yn(yn1, yn2...ynn), wherein Xn the main element before a reaction, Xnn is the computing parameters of the Xn, yn is the main element after the reaction, ynn is the computing parameters of yn, f is the algorithm formula;
2) enabling the subject user to control the Virtual Character performs f1 action to the xn in the virtual environment and adjust the xnn value of the xn to the setting value of the subject user; 3) computing and recording the yn value and ynn value according to the algorithm formula of the step 1).

In the embodiment, if the experiment needs to reflect several times reaction of one law of nature, or several times reaction of several laws of nature, the steps 2)-4) are performed according the requirement.

The experiment method has no the risk of hurting the subject user while has zero cost and high experiment precision.

**The seventh embodiment, a man-machine controlling method, which is applied to travel,** includes the steps of:
1) modeling the 3D model to the tourist areas;
2) enabling the subject user to control the Virtual Character to perform the virtual action in the 3D model of the step 1) using the man-machine interaction controlling method of the first embodiment.

### The following are the preferred embodiments provided by the present invention.

### Preferable Embodiment 1

The present invention provides a method for controlling man-machine interaction, wherein, a subject user performs smaller-actions to control a Virtual Character in a virtual environment to perform virtual-actions, the method comprises steps of :
1) creating the Virtual Character in the virtual environment;
2) receiving continuous motion-capture data representing dynamic motion of at least one of a bone or a joint of the subject user while performing a physical movement;
3) performing the smaller-actions by the subject user while sitting or lying on an operating position;
4) enabling the Virtual Character to perform virtual-actions which enlarge the motion-capture data of the subject user,and satisfying the, action enlarging rules wouldn't cause the subject user leaving away from the operation position.

### Preferable Embodiment 2

Compared with the man-machine controlling method as claimed in Preferred Embodiment 1, the present preferred embodiment further limits the amplitude of the user's limb activity, so that the restricted corresponding parts can fully perform smaller-actions without the body leaving its position.

### Preferable Embodiment

Compared with the man-machine controlling method as claimed in Preferred Embodiment 1 or 2, in the present preferred embodiment, further, the user's permitted smaller-action plan set up a maximum range value M for each of the smaller-actions which are performed by the user or a prop, a maximum range value N is set for the virtual-actions which are performed by the Virtual Character, supposing the action-range of the smaller-action permitted by the user at time t is Mt, the action-range of the virtual permission action performed by the Virtual Character is Nt, then if Mt≥M, Nt=N; if Mt<M, N>Nt>Mt.

### Preferable Embodiment 4

Compared with the man-machine controlling method as claimed in Preferred Embodiment 3, in the present preferred embodiment, further restricting the user's permitted smaller-action plan, when the user completes any smaller-actions with the largest action-range of M, the angle change value of any adjacent two parts on the torso except the palms and feet is less than 30 degrees.

### Preferable Embodiment 5

Compared with the man-machine controlling method as claimed in Preferred Embodiment 1, in the present preferred embodiment, further, enable the virtual character to perform the same range of motion as the user in one or more parts of the head, including the palm of the wrist, including the foot of the ankle.

### Preferable Embodiment 6

Compared with the man-machine controlling method as claimed in Preferred Embodiment 1, in the present Preferred Embodiment, at least one or more of the following step characteristics are included:
1) When any object of the virtual environment acts on a part or parts of the Virtual Character, the corresponding part of the user will be acted on according to the action characteristics of the object;
2) Determining the reaction user-body-parts and effect acted to the Virtual Character to make the corresponding acted user-body-parts is proportional to the determined reaction effect according to the action characters and the instantaneous state of the Virtual Character when the Virtual Character acts to any object in the virtual environment;
   When the Virtual Character acts on any object of the virtual environment, first of all, according to the action characteristics of the Virtual Character and the immediate state of the object, judge the Virtual Body Parts and reaction effect which is reacted on, so that the corresponding part of the user is acted on with equal factor effect;
3) Create a set or sets of the user's permitted smaller-action plans and one or more virtually permitted action plans that can be recognized by the computer;
4) So that the users in the human-machine interaction process can only see the animation of the virtual environment and not see the body of himself/herself;
5) The images of the virtual environment cover all the vision range of the subject user.

### Preferable Embodiment 7

Compared with the man-machine controlling method as claimed in Preferred Embodiment 6, in the present preferred embodiment, making the corresponding parts of the subject user to be acted with a certain proportion load that the subject user is able to receive according to the physical fatigue degree or the biggest motion ability of the Virtual Character.

### Preferable Embodiment 8

Compared with the man-machine controlling method as claimed in Preferred Embodiment 1, the selection method and/or combination method are also used in the present preferred embodiment; the selection method is to allow the user to choose other activity parts to replace when the user does not have the corresponding activity part of the Virtual Character; the combination method is that when the number of user activity parts is less than the number of activity parts of the Virtual Character, a shared activity bit is set on the user-body-parts to control more than one active part of the Virtual Character.

### Preferable Embodiment 9

Compared with the man-machine controlling method as claimed in Preferred Embodiment 8, the combination method also includes one or more of the following steps characteristics in the present Preferred Embodiment:
1) When it is necessary to switch the activity parts of the Virtual Character, different activity parts can be common selected to perform different activities by the 3rd command or by using other active joints;
2) Combine the share part with one or more kinetic body-parts to control the Virtual Action Plan together.

### Preferable Embodiment 10

Compared with the man-machine controlling method as claimed in Preferred Embodiment 1, the present Preferred Embodiment includes at least one or more methods of tracking the user's smaller-actions method, the determination method of the scene in which the Virtual Character is located, and the method of reverse motion control;
1) The method of tracking user's smaller-action is setting the positioning sensor on N1, N2...Nn on corresponding user-body-parts, set up three or more ranging devices in positions not in the same straight line within the user's environment, and perform the following steps:
   1.1) Create a virtual three-dimensional coordinates, and determine the coordinates of each ranging device, measure the distance between each arbitrary positioning sensing device at any time and three ranging devices, the three-dimensional coordinates of each positioning sensor at that point in time are calculated from the out;
   1.2) N1, N2...Nn on corresponding user-body-parts, tracing the 3D position change of each of the position sensing elements at any time, controlling the Virtual Body-Parts of the Virtual Character to perform actions.
   1.3) According to the change of the three-dimensional coordinates of different positioning sensors over time, describe the activity of the corresponding parts of the user during the t-period, and make the corresponding parts of the Virtual Character simultaneously enlarge the performance range of the activities;
2) The method of determining the scenario in which the Virtual Character is located includes the following steps:
   2.1) First determine the positioning device located in the user's head or indirectly located in the user's head, which can move synchronously with the head; The position in the virtual environment at least three points that are not in the same line on the locating piece can be determined;
   2.2) Track the position of the user's head and face orientation in the virtual environment, and determine the virtual environment picture by the position of the user's head and face orientation in the virtual environment, that is the display frame of the imaging device;
3) The reverse motion control method is to make the scene in which the self-character is located in the virtual world perform vector actions in the opposite direction to the direction of the self-character's head, and the two are in the coordinate system of the same vector action and time axis respectively, and the vector action time graph is axis-symmetrical with the time axis.

### Preferred Embodiment 11

The present invention further provides a man-machine interaction controlling system, a user performs a user permitted smaller-action to control a Virtual Character in a virtual environment to perform virtual-actions, wherein the system comprises an imaging device, an operation platform, a recognizing and capturing device for recognizing and capturing the smaller-action-plan, and a synchronization controlling system for controlling the synchronization of the actions of the subject user and Virtual Character.

### Preferred Embodiment 12

Compared with the man-machine interaction controlling system as claimed in Preferred Embodiment 11, in the present embodiment,displaying the imaging device of the virtual environment to make the images of the virtual environment cover the vision of user and enabling the subject user only to see the animation view of the virtual environment and do not see the body of himself/herself.

### Preferred Embodiment 13

Compared with the man-machine interaction controlling system as claimed in Preferred Embodiment 11, in the present embodiment, The recognizing and capturing device sets one or more position sensing element with different distinctive characters on the user-body-parts, to enable the system could capture the gesture or action change of the user -body-part corresponding to the sensing positioning points.

### Preferred Embodiment 14

Compared with the man-machine interaction controlling system as claimed in Preferred Embodiment 13, in the present embodiment, the wearable controlling device includes palm sets, arm sets, head sets, sole sets, leg sets, buttock sets, and waist set. Each of the above sets one or more than one sensing positioning points.

### Preferred Embodiment 15

Compared with the man-machine interaction controlling system as claimed in Preferred Embodiments 11 or 12 or 13 or 14,In the present preferred embodiments, further the system sets one obstacle system,the obstacle system sets limit mechanism, The limit mechanism limit the range of movement of the user's body, and enabling the limited parts can perform the smaller-action at a maximum range M and need not leave away from the operation position.

### Preferred Embodiment 16

Compared with the man-machine interaction controlling system as claimed in Preferred Embodiment 15,In the present preferred embodiment, further, the obstacle system includes a reaction sensing device and an action sensing device. Through the action sensing device, when any object in the virtual environment acts to one or some parts of the Virtual Character the obstacle system acts to the corresponding parts of the subject user according to the characters of the action of the object.

The reaction sensing device is required: when the Virtual Character acts to any object of the virtual environment, the obstacle system concludes the reaction parts and reaction effect to the Virtual Character according to the action characters and the state at that time of the object, and the obstacle system acts to the corresponding parts of the subject user proportionally.

### Preferred Embodiment 17

Compared with the man-machine interaction controlling system as claimed in Preferred Embodiment 16, In the present preferred embodiment, further, The obstacle system changes the load which the reaction sensing device and the action sensing device put on the subject user according to the physical fatigue degree or the biggest motion ability of the Virtual Character.

### Preferred Embodiment 18

Comparing with the a man-machine interaction controlling system as claimed in Preferred Embodiment 16 and 17, In the present preferred embodiment, further comprising one or more of the following features:
1) The recognizing and capturing device sets one or more position sensing element with different distinctive characters on the user-body-parts, to enable the system could capture the gesture or action change of the user -body-part corresponding to the sensing positioning points;
2) The device further includes one or more of a olfactory system, a tactile system, a physical fatigue random obstacle system;
3) The wearable controlling device includes palm sets, arm sets, head sets, sole sets, leg sets, buttock sets, and waist set. Each of the above sets one or more than one sensing positioning points.

### Preferred Embodiment 19

The present invention further provides a man-machine controlling method which is applied to a Game Software, The virtual environment as claimed in the Preferred Embodiment 1 at least includes one or more of a future environment, a past environment, and dream environment.

### Preferred Embodiment 20

The present invention further provides a man-machine controlling method which is applied to a Game Software provides the super ability to the Virtual Character includes the steps of:
1) Creating the virtual-actions of super ability of the Virtual Character excepting the ability for enlarging the stamina of the subject user;
2) Capturing the change of the smaller-action of the subject user and determining the acted object of the virtual permission action of super ability of the Virtual Character,
3) Evaluating the evaluation indicators of the super ability of the Virtual Character during performing the virtual permission action of the super ability to make the acted object generate morphology angel proportionally.

### Preferred Embodiment 21

Comparing with the a man-machine controlling method as claimed in preferred embodiment 19 and 20, Additionally, In the present preferred embodiment, the present invention opens the authority to the subject user to reset the parameters of the object in the virtual environment, thus enables the subject user to establish, adjust, delete the virtual environment, and thereby, the subject user can easily realize the virtual object. The present invention far surpasses the traditionally tools.

### Preferred Embodiment 22

The present invention further provides a man-machine controlling method which is applied to the exhibition and communication of the space design and space sample, includes the steps of:
1) Modeling 3D model for the space design and space sample;
2) Enabling the subject user to use the man-machine interaction controlling method of the first embodiment to control the Virtual Character to perform the virtual actions in the 3D model modeled for the space design and space sample.

### Preferred Embodiment 23

The present invention further provides a man-machine controlling method, which is applied to shoot a movie, includes the steps of:
1) Modeling a 3D model for movie scenes;
2) Enabling the actors to use the man-machine interaction controlling method of the first embodiment to control the Virtual Character to perform the virtual actions in the 3D model modeled in the step 1);
3) Recording the required scenes in the 3D model and the images of the virtual actions performed by the Virtual Character.

### Preferred Embodiment 24

The present invention further provides a man-machine controlling method, which is applied to simulate an experiment, includes the steps of:
1) Collecting the known laws of nature and establishing algorithm f[x1(x11, x12...x1n), x2 (x21, x22...x2n)...xn(xn1, xn2...xnn)]= y1(y11, y12...y1n), y2 (y21, y22...y2n)...yn(yn1, yn2...ynn), wherein Xn the main element before a reaction, Xnn is the computing parameters of the Xn, yn is the main element after the reaction, ynn is the computing parameters of yn, f is the algorithm formula;
2) Enabling the subject user according to the man-machine controlling method as claimed in Preferred Embodiment 21,to control the Virtual Character performs f1 action to the xn in the virtual environment and adjust the xnn value of the xn to the setting value of the subject user;
3) Enabling the subject user according to the man-machine controlling method as claimed in Preferred Embodiment 1-3, to control the Virtual Character performs f1 action to the xn in the virtual environment and adjust the xnn value of the xn to the setting value of the subject user.
4) Computing and recording the yn value and ynn value according to the algorithm formula of the step 1).

### Preferred Embodiment 25

The present invention further provides a man-machine controlling method, which is applied to travel, includes the steps of:
1) Modeling the 3D model to the tourist areas;
2) Enabling the subject user to control the Virtual Character to perform the virtual action in the 3D model of the step 1) using the man-machine interaction controlling method of the first embodiment.

## Claims

1. A man-machine interaction controlling method,wherein a subject user performs smaller-actions to control a Virtual Character in a virtual environment to perform virtual-actions,the method comprises steps of:
1) creating the Virtual Character in the virtual environment;
2) receiving continuous motion-capture data representing dynamic motion of at least one of a bone or a joint of the subject user while performing a physical movement;
3) performing the smaller-actions by the subject user while sitting or lying on an operating position;
4) enabling the Virtual Character to perform virtual-actions which enlarge the motion-capture data of the subject user,and satisfying the action enlarging rules wouldn't cause the subject user leaving away from the operation position.

2. The man-machine interaction controlling method as claimed in claim 1, establishing one or more sets of smaller-action-plan or one or more sets of Virtual Action Plan, which can be recognized by computer.

3. The man-machine interaction controlling method as claimed in claim 1or 2,the action enlarging rules further comprising one or more of following features 3.1), 3.2) or 3.3):
3.1) wherein a maximum range value M is set for each of the smaller-actions which are performed by of the subject user or a prop,a maximum range value N is set for the virtual-actions which are performed by the Virtual Character the N is less than a movement limit of the corresponding user-body-part of the subject user,supposing the action range of the smaller-action performed by the subject user at time t is Mt,the action range of the virtual -action performed by the Virtual Character is Nt,then if Mt≥M,Nt=N; if Mt<M, N>Nt>Mt;
3.2) Making the Virtual Character and the user perform the same action-range of on one or more parts of the head, the palm of the hand including the wrist, and the soles of the foot including the ankle;
3.3 permitting at least two Virtual Body-Parts whose enlarging proportions are not 1 to have different enlarging proportions.

4. The man-machine interaction controlling method as claimed in claim 3,which is **characterized in that** when the control method includes the feature 3.1),Limiting the smaller-action plan, and satisfies: when the subject user finishes one smaller-action with the maximum range M,the angle change of any two adjacent parts of user's body,excepting palm and sole,is less than 30.

5. The man-machine interaction controlling method as claimed in claim 1, further comprising one or more of following additional features A), B), C) or D), wherein:
A) limiting a maximum movement range of user's limbs and enabling the limited parts can perform the smaller-action completely and need not leave away from the operation position;
B) wherein including at least one or more of the following step characteristics:
1) the action sensing device acting to the corresponding parts of the user according to the characters of the action of the object when any object in the virtual environment acts to one or some Virtual Body-parts of the Virtual Character;
2) the reaction sensing device determining the reaction parts and effect acted to the Virtual Character to make the corresponding acted parts of the user to be proportional to the determined reaction effect according to the action characters and the instantaneous state of the Virtual Character;
3) enabling the subject user only to see animation view of the virtual environment and not to see the body of himself/herself;
4) enabling images of the virtual environment to cover vision of the subject user;
C) wherein a selecting method and/or a combination method are used,the selecting method is permitting the subject user select other user-body-parts to replace the corresponding Virtual Body-parts of the Virtual Character when the subject user has no the parts corresponding to the Virtual Body-parts of the Virtual Character ; the combination method is setting a share part on the subject user's body to control more than one Virtual Body-parts of the Virtual Character when the number of the user-body-parts is less than that of the Virtual Body-parts;
D) wherein including at least one or more of the user smaller-action tracking method, the scene of Virtual Character determining method and Reverse actions controlling method;
1) the user smaller-action tracking method is setting respectively position sensing elements on N1, N2...Nn user-body-parts, and three or more position sensing elements are set in the locations not on the same line in the user's environment, and the following steps are performed:
1.1 establishing a virtual three-dimensional coordinates, and determines the coordinates of the three or more than three distance measurement points which are not on the same straight line in a coordinate system; measuring the distance between the position sensing elements and each of the distance measurement points, and then computing the three-dimensional coordinates of each of the position sensing elements at any time;
1.2 tracing the 3D position change of each of N1, N2...Nn position sensing elements at any period t;
1.3 according to the 3D position change of different position sensing elements, getting the motion-capture data of the subject user, and enabling the Virtual Character to perform virtual-actions which enlarge the action-range of the user by the motion-capture data ;
2) the method for determining the scene wherein the Virtual Character is in includes:
2.1 directly fixing positioning element,which can be moved simultaneously with a head,on the head of the subject user,the positioning element defines three position sensing elements that are not on a same straight line,the positions of the position sensing elements can be determined in the virtual environment,and thereby,the position and facial direction that the face towards of the head in the virtual environment;
2.2 tracking the position and face orientation of the user's head in the virtual world, and determining the images of the virtual environment according to the position and facial direction of the head in the virtual environment;
3) Reverse actions controlling method, making the virtual environment where the Virtual Character is in performs vector actions which have same vector value and reverse direction with the command given by the subject user, and the two are in the coordinate system with the same vector action and time as the coordinate axis respectively, and the time diagram of the vector action is axisymmetric with the time coordinate axis.

6. The man-machine interaction controlling system as claimed in claim 13: making the corresponding parts of the subject user to be acted with a certain proportion load that the subject user is able to receive according to the physical fatigue degree or the biggest motion ability of the Virtual Character.

7. The man-machine interaction controlling method as claimed in claim5, which is **characterized in that** when the control method includes the feature C), the combination method further comprising one or more of the following steps:
1) selecting other Virtual Body-Parts by a command or in cooperating with other kinetic part/body-parts when the Virtual Body-Parts of the Virtual Character is required to switch;
2) combing the share part with one or more kinetic part/body-parts to control the Virtual Action Plan together.

8. The man-machine interaction controlling system, a user performs a user permitted smaller-action on an operation position to control a Virtual Character in a virtual environment, wherein the system comprises an imaging device, an operation platform, a recognizing and capturing device for recognizing and capturing the smaller-action-plan, and a synchronization controlling system for controlling the synchronization of the actions of the subject user and Virtual Character.

9. The man-machine interaction controlling system as claimed in claim 8: displaying the imaging device of the virtual environment to make the images of the virtual environment cover the vision of user and enabling the subject user only to see the animation view of the virtual environment and do not see the body of himself/herself.

10. The man-machine interaction controlling system as claimed in claim 9: the recognizing and capturing device including a plurality of position sensing elements with different distinct characters to make the computer to recognize the user's parts corresponding to the position sensing elements.

11. The man-machine interaction controlling system as claimed in claim 10, which is **characterized in that** the wearable controlling device includes one or more of a palm kit, an arm kit, a head kit, a sole kit, a leg kit, a hip kit and a waist kit, each of the above set one or more than one sensing positioning points.

12. The man-machine interaction controlling system as claimed in claim 8/9/10/11: the operation platform includes an operation position and an obstacle system, the obstacle system provides a limitation mechanism to limit the movement range of the subject user's limbs to make the limited parts perform the permitted action at a maximum range M and ensure the subject user continuously perform any controlling action while the subject user is not required to leave away from the operation position.

13. The man-machine interaction controlling system as claimed in claim 12, wherein the obstacle system further including a reaction sensing device and/or action sensing device;
the action sensing device acting to the corresponding parts of the user according to the characters of the action of the object when any object in the virtual environment acts to one or some parts of the Virtual Character;
reaction sensing device determining the reaction parts and effect acted to the Virtual Character to make the corresponding acted parts of the user to be proportional to the determined reaction effect according to the action characters and the instantaneous state of the Virtual Character.

14. The man-machine interaction controlling system described as claimed in claim 13, which is **characterized in that** the obstacle system can change the load of the reaction sensing device and the acted sensing device on the user according to the fatigue degree or the biggest motion ability of the Virtual Character.

15. The man-machine interaction controlling system as claimed in claim 13 or14, further comprising one or more of the following features:
1) the recognizing and capturing device including a plurality of position sensing elements with different distinct characters to make the computer to recognize the user's parts corresponding to the position sensing elements;
2) the system further comprising one or more of a olfactory system, a tactile system, a physical fatigue random obstacle system;
3) the Identification capture device also comprises a set of fixed-point control equipment, including one or more of a palm kit, an arm kit, a head kit, a sole kit, a leg kit, a hip kit and a waist kit, each of the above set one or more than one sensing positioning points.
